# FASCICULE DE BREVET EUROPEEN

(11) **EP 2 345 093 B1**
(45) Date de publication et mention de la délivrance du brevet: **19.09.2012**
(21) Numéro de dépôt: 09752203.1
(22) Date de dépôt: 13.10.2009
(51) Int. Cl.: H01L 37/04, F25B 21/00, F25B 29/00

(54) **GENERATEUR THERMIQUE A MATERIAU MAGNETOCALORIOUE**
THERMISCHER GENERATOR MIT MAGNETOKALORISCHEM MATERIAL
THERMAL GENERATOR WITH MAGNETOCALORIC MATERIAL

(30) Priorité: 14.10.2008 FR 0805666
(43) Date de publication de la demande: 20.07.2011
(73) Titulaire: Cooltech Applications S.A.S., 67810 Holtzheim (FR)
(72) Inventeur: HEITZLER, Jean-Claude, F-68180 Horbourg-Wihr (FR); MULLER, Christian, F-67000 Strasbourg (FR)
(74) Mandataire: Nithardt, Roland
(86) Numéro de dépôt international: PCT/FR2009/001199
(87) Numéro de publication internationale: WO 2010/043781

(56) Documents cités:
- WO-A-2004/059221
- WO-A-2005/093343
- WO-A-2007/026062
- US-A1- 2007 125 095

## Description

### Domaine technique :

La présente invention concerne un générateur thermique comprenant au moins un module thermique essentiellement constitué par un élément magnétocalorique agencé pour être traversé par un fluide caloporteur et deux chambres chaude et froide disposées de part et d'autre de l'élément magnétocalorique et renfermant chacune un moyen de déplacement dudit fluide caloporteur à travers ledit élément magnétocalorique, un arrangement magnétique agencé pour créer une variation de champ magnétique dans ledit élément magnétocalorique de manière à créer alternativement dans ledit élément magnétocalorique un cycle d'échauffement et un cycle de refroidissement, et un dispositif d'entraînement desdits moyens de déplacement selon un mouvement de va-et-vient dans la chambre concernée pour imprimer un déplacement au fluide caloporteur de part et d'autre dudit élément magnétocalorique et de manière synchronisée avec la variation de champ magnétique afin de générer la création puis le maintien d'un gradient de température entre les deux extrémités opposées dudit élément magnétocalorique.

### Technique antérieure :

La technologie du froid magnétique est connue depuis plus d'une vingtaine d'années et on sait les avantages qu'elle apporte en termes d'écologie et de développement durable. On connaît également ses limites quant à sa puissance calorifique utile et à son rendement. Dès lors, les recherches menées dans ce domaine tendent toutes à améliorer les performances d'un tel générateur, en jouant sur les différents paramètres, tels que la puissance d'aimantation, les performances de l'élément magnétocalorique, la surface d'échange entre le fluide caloporteur et les éléments magnétocaloriques, les performances des échangeurs de chaleur, etc.

La demande de brevet français n° 07 / 07612 au nom de la demanderesse décrit un générateur magnétocalorique dans lequel l'énergie thermique générée par des éléments magnétocaloriques est échangée avec un fluide caloporteur mis en déplacement à travers lesdits éléments magnétocaloriques par l'intermédiaire de moyens de circulation. Ces moyens de circulation sont sous la forme de pistons entraînés selon un mouvement de va-et-vient par une came de commande comportant un profil de came spécifique.

Un autre générateur générateur thermique est divulgué en WO 2007/026062.

Ce générateur présente toutefois un inconvénient inhérent à l'entraînement de ces pistons. En effet, cet entraînement est sujet à une usure des éléments en contact, à savoir le profil de came et les pistons, ce qui peut entraîner une dégradation prématurée du rendement du générateur. De plus, il pose des problèmes d'étanchéité entre la chemise des pistons et le mécanisme d'entraînement.

### Explosé de l'invention:

La présente invention vise à pallier ces inconvénients en proposant un générateur thermique magnétocalorique de construction simple avec un nombre réduit d'éléments constitutifs, dans lequel, d'une part, les risques de perte d'étanchéité entre la chambre dans laquelle se déplacent les moyens de circulation du fluide et le moyen de manoeuvre de ces derniers sont fortement limités et, d'autre part, dont la durée de vie est augmentée et le rendement préservé.

Dans ce but, l'invention concerne un générateur thermique du genre indiqué en préambule, caractérisé en ce que le dispositif d'entraînement comporte un circuit fermé de fluide reliant fluidiquement lesdites chambres chaude et froide dans lequel un fluide de manoeuvre est entraîné par un dispositif d'aspiration et de refoulement, et au moins une interface de commutation synchronisée avec ledit arrangement magnétique pour relier alternativement chaque chambre chaude et froide aux côtés aspiration et refoulement dudit dispositif d'aspiration et de refoulement et inversement.

Le générateur thermique comporte ainsi un unique dispositif d'entraînement des moyens de déplacement du fluide caloporteur. L'utilisation de ladite interface de commutation permet d'éviter l'utilisation de vannes de commutation ou autres dispositifs analogues et facilite ainsi la conception du générateur thermique. En outre, l'intégration de cette interface dans le générateur thermique selon l'invention permet de réduire l'encombrement de ce dernier.

Le générateur thermique selon l'invention est destiné à échanger de l'énergie thermique avec un ou plusieurs circuits extérieurs d'utilisation (chauffage, climatisation, tempérage, etc.) en y étant relié par l'intermédiaire d'un échangeur de chaleur, par exemple.

Selon l'invention, le fluide de manoeuvre et le fluide caloporteur peuvent être les mêmes.

De préférence, ladite interface de commutation peut comporter au moins une platine de commutation montée dans ledit générateur thermique et intercalée entre une des chambres chaude ou froide dudit module thermique et un flasque de distribution muni d'un circuit d'aspiration et d'un circuit de refoulement reliés respectivement aux côtés aspiration et refoulement du dispositif d'aspiration et de refoulement.

Ladite platine de commutation peut comporter des passages traversants assurant une communication fluidique entre lesdites chambres chaude et froide et les circuits d'aspiration et de refoulement dudit flasque de distribution.

Dans un mode de réalisation préféré de l'invention, le générateur thermique peut présenter une structure circulaire comportant une pluralité de modules thermiques disposés en cercle autour d'un axe central.

Dans cette configuration, il peut comprendre deux interfaces de commutation comportant chacune une platine de commutation, lesdites platines de commutation et les flasques de distribution correspondants peuvent également être circulaires et les circuits d'aspiration et de refoulement desdits flasques de distribution peuvent être sous la forme de deux rainures concentriques réalisées sur leur face située en regard desdites platines de commutation.

Dans une première variante, l'arrangement magnétique peut être concentrique à l'axe central et entraîné en rotation autour dudit axe et les platines de commutation et l'arrangement magnétique peuvent être entraînés en rotation autour dudit axe central par le même actionneur. Cette configuration permet d'augmenter la compacité du générateur thermique.

Dans une seconde variante, l'arrangement magnétique peut être fixe et constitué par des électroaimants reliés à une source d'énergie électrique et les platines de commutation peuvent être entraînées en rotation autour dudit axe central par un actionneur spécifique.

En outre, les platines de commutation peuvent être identiques et être montées décalées angulairement l'une par rapport à l'autre de telle sorte que chaque module thermique est relié, d'une part, au niveau de sa chambre chaude ou froide, à un passage traversant d'une platine de commutation relié au circuit d'aspiration d'un flasque de distribution et, d'autre part, au niveau de sa chambre froide ou chaude, à un passage traversant de l'autre platine de commutation relié au circuit de refoulement de l'autre flasque de distribution.

Le fait d'intégrer des platines de commutation identiques permet de réduire le coût de fabrication du générateur.

En ce qui concerne l'arrangement magnétique, ce dernier peut comporter une alternance de zones aimantées et de zones non aimantées et les passages traversants des platines de commutation peuvent être disposées en fonction de ladite alternance, pour réaliser un déplacement du fluide caloporteur dans chaque module thermique de la chambre chaude vers la chambre froide lorsque l'élément magnétocalorique n'est pas soumis à un champ magnétique et de la chambre froide vers la chambre chaude lorsque l'élément magnétocalorique est soumis à un champ magnétique.

En outre, selon l'invention, l'ensemble des chambres chaudes et l'ensemble des chambres froides peuvent être contenus dans un carter pouvant constituer un échangeur thermique.

### Description sommaire des dessins :

La présente invention et ses avantages apparaîtront mieux dans la description suivante d'un mode de réalisation donné à titre d'exemple non limitatif, en référence aux dessins annexés, dans lesquels:

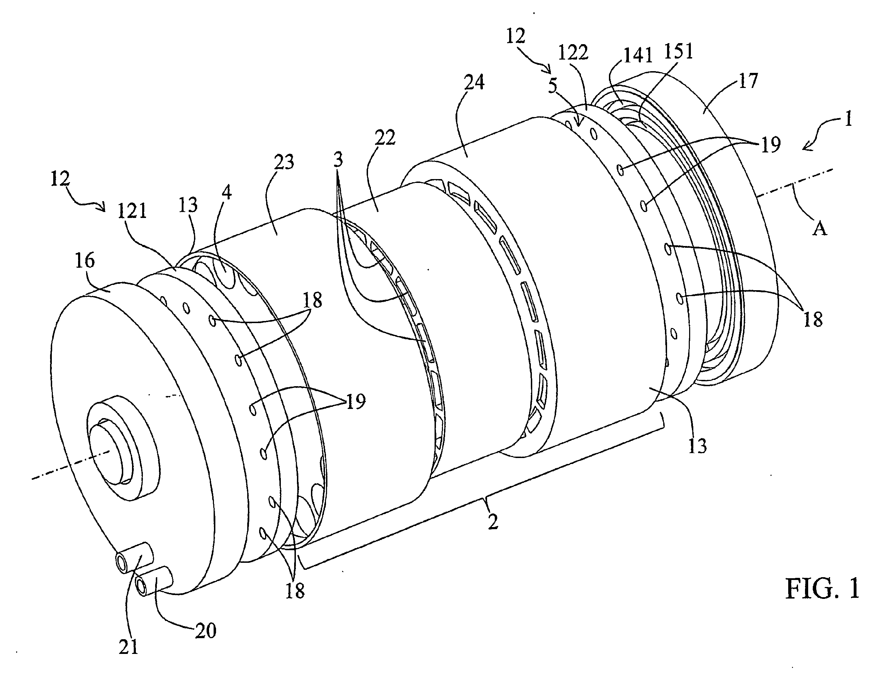

- la figure 1 est une vue en perspective éclatée d'un générateur thermique selon l'invention,
- la figure 2 est une vue en coupe longitudinale du générateur thermique représenté à la figure 1,
- la figure 3 est une vue en perspective d'un flasque de distribution du générateur thermique représenté à la figure 1,
- la figure 4 est une vue en perspective d'une platine de commutation du générateur thermique représenté à la figure 1, et

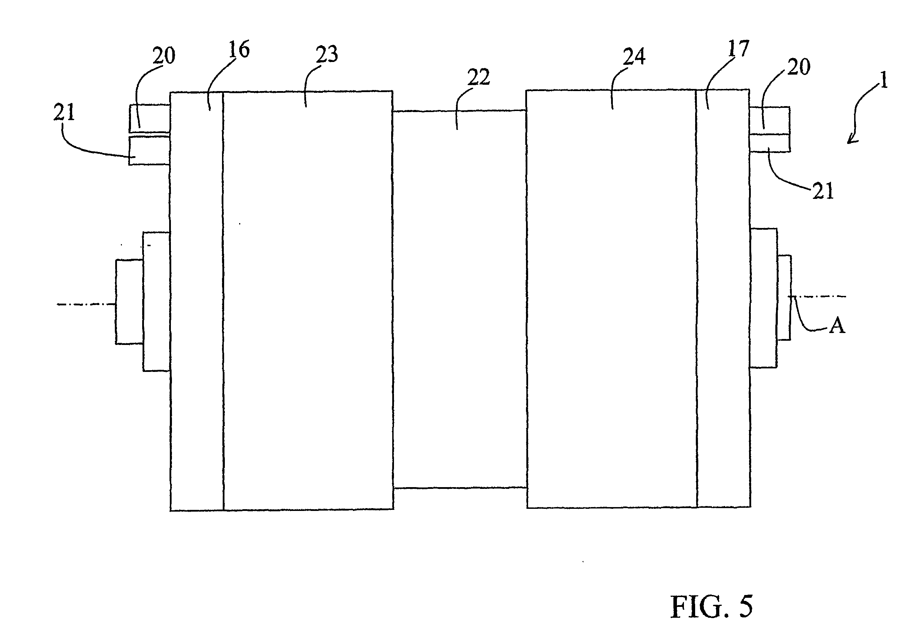

- la figure 5 est une vue en élévation latérale du générateur thermique représenté à la figure 1.

### Meilleure manière de réaliser invention :

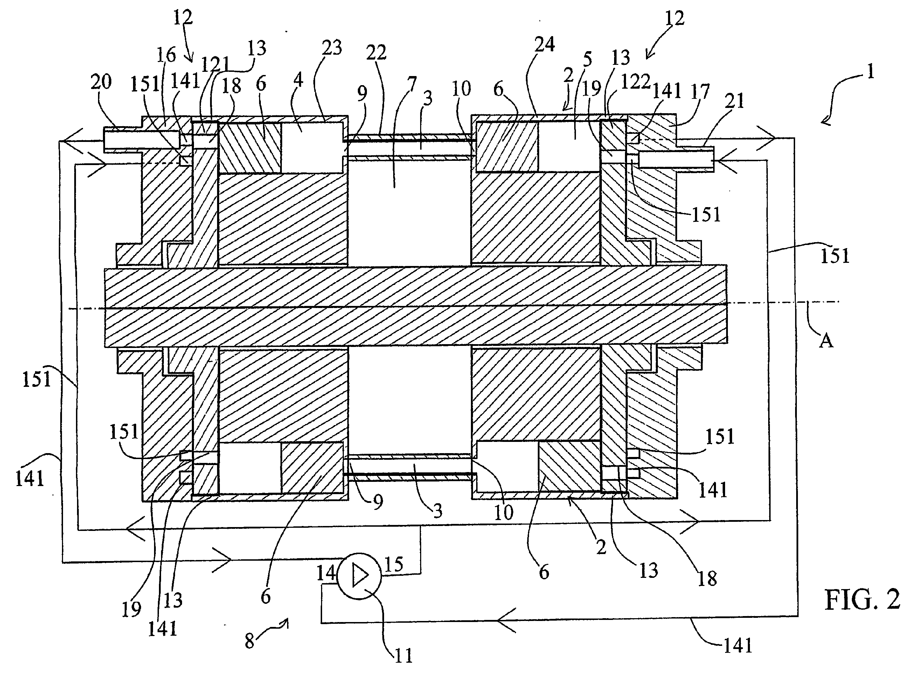

En référence aux figures annexées, le générateur thermique 1 est de configuration sensiblement circulaire. Il comporte une pluralité de modules thermiques 2 disposés en cercle autour d'un axe A et renfermant chacun un élément magnétocalorique 3 disposé entre deux chambres chaude 4 et froide 5 et deux moyens 6 de déplacement d'un fluide caloporteur à travers ledit élément magnétocalorique 3. Ces moyens de déplacement sont sous la forme de pistons 6 (cf. figure 2) disposés dans lesdites chambres chaude 4 et froide 5, entre le fond de ces dernières et l'extrémité chaude 9 ou froide 10 dudit élément magnétocalorique 3.

Par fond d'une chambre chaude 4 ou froide 5, il faut comprendre l'extrémité de ladite chambre opposée à l'élément magnétocalorique 3.

Ledit élément magnétocalorique 3 est perméable au fluide caloporteur et peut être constitué par un ou plusieurs matériaux magnétocaloriques. Il comporte des passages de fluide débouchants qui peuvent être constitués par les pores d'un matériau poreux, des mini ou micro-canaux usinés dans un bloc plein ou obtenus par un assemblage de plaques rainurées superposées, par exemple.

Ledit générateur thermique 1 renferme également un arrangement magnétique 7 comportant des zones aimantées et des zones non aimantées, entraîné en rotation par un actionneur (non représenté) de manière à soumettre chaque élément magnétocalorique 3 à une variation de champ magnétique et créer alternativement, dans chaque élément magnétocalorique 3, un cycle d'échauffement et un cycle de refroidissement. Les pistons 6 sont déplacés de manière synchronisée avec ledit arrangement magnétique 7 de manière à faire circuler le fluide caloporteur alternativement de part et d'autre de chaque élément magnétocalorique 3 et de générer la création puis le maintien d'un gradient de température entre les deux extrémités opposées 9 et 10 de chaque élément magnétocalorique 3.

Selon l'invention, les pistons 6 sont déplacés par un dispositif d'entraînement 8 comportant un fluide de manoeuvre intégré dans un circuit fermé reliant les fonds des chambres chaudes 4 et froides 5 et pouvant être différent ou non du fluide caloporteur. De préférence, ce fluide de manoeuvre des pistons 6 et le fluide caloporteur sont identiques, de telle manière qu'une fuite éventuelle n'entrave pas le bon fonctionnement du générateur thermique 1.

Le fluide de manoeuvre des pistons 6 est entraîné par un unique dispositif 11 d'aspiration et de refoulement continus. Ce dispositif fonctionne de manière continue et présente un côté aspiration 14 et un côté refoulement 15 aspirant et refoulant de manière continue le fluide de manoeuvre. Un tel dispositif peut être une pompe centrifuge, par exemple. Il déplace les pistons 6 alternativement dans les deux sens de circulation par l'intermédiaire de deux interfaces de commutation 12 comportant chacune une platine de commutation 121, 122 reliant respectivement et de manière alternée le fond des chambres chaudes 4 ou froides 5 aux circuits d'aspiration 141 et de refoulement 151 prévus dans deux flasques de distribution 16 et 17 dudit fluide correspondants. Ces flasques de distribution 16 et 17 circulaires sont disposés de part et d'autre des modules thermiques 2 et comportent des embouts 20, 21 permettant leur raccordement au dispositif 11 d'aspiration et de refoulement. A cet effet, l'embout 20 des flasques de distribution 16 et 17 relie leur circuit d'aspiration 141 au côté aspiration 14 du dispositif 11 d'aspiration et de refoulement tandis que l'embout 21 desdits flasques de distribution 16 et 17 relie leur circuit de refoulement 151 au côté refoulement 15 dudit dispositif 11 d'aspiration et de refoulement.

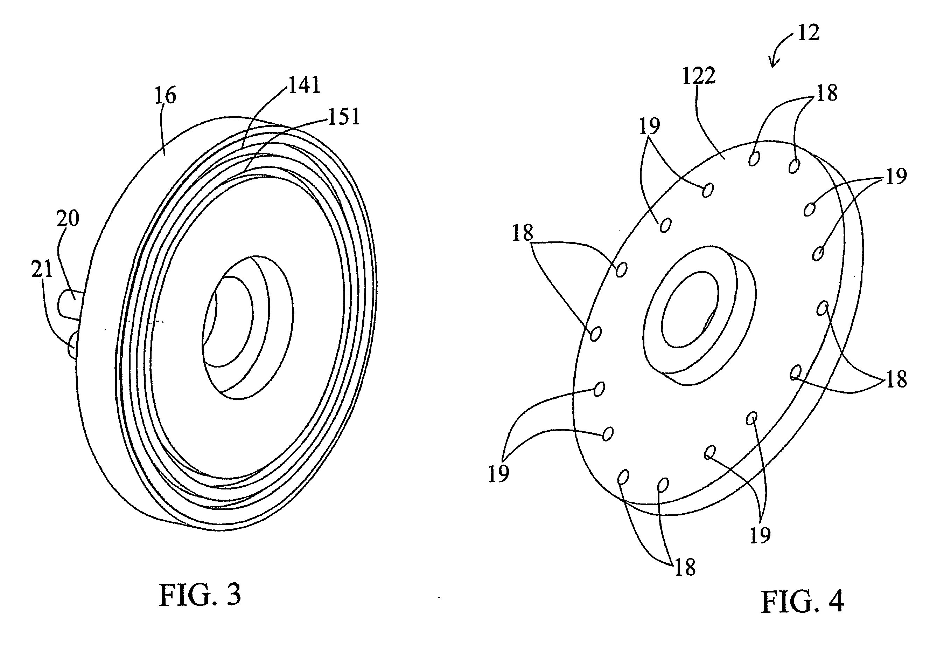

Ces flasques de distribution 16 et 17 coopèrent avec les platines de commutation 121 et 122 également circulaires et entraînées en rotation par le même actionneur que celui de l'arrangement magnétique 7. Elles comportent des passages traversants 18 et 19 mettant en communication de manière alternée le fond des chambres chaudes 4 et froides 5 des modules thermiques 2 avec les circuits d'aspiration 141 et de refoulement 151 correspondants des flasques de distribution 16 et 17. Les circuits d'aspiration 141 et de refoulement 151 desdits flasques de distribution 16 et 17 sont formés par deux rainures concentriques (cf. figure 3) réalisées dans leur face située en regard des platines de commutation 121 et 122 en position montée du générateur thermique 1 et respectivement en regard des passages traversants 18 et 19 (cf. figure 4).

Bien entendu, une autre configuration des circuits d'aspiration 141 et de refoulement 151 peut être prévue sans pour autant sortir du champ de protection de l'invention. Dans ce cas, les platines de commutation 121 et 122 sont également adaptées pour pouvoir coopérer avec lesdits circuits.

De même, dans une configuration non représentée, l'arrangement magnétique peut être réalisé par des électroaimants soumis à un champ électrique variable et un actionneur spécifique peut être prévu pour faire tourner les platines de commutation 121 et 122.

De ce fait, en considérant par exemple le module thermique 2 représenté sur la partie supérieure de la figure 2, le fluide caloporteur contenu dans ce dernier s'est déplacé de droite à gauche sur ladite figure. Pour ce faire, un passage traversant 19 de la platine de commutation 122 relié au circuit de refoulement 151 du flasque de distribution 17 correspondant s'est positionné face à la chambre froide 5 tandis qu'un passage traversant 18 de la platine de commutation 121 relié au circuit d'aspiration 141 du flasque de distribution 16 correspondant s'est positionné face à la chambre chaude 4 du même module thermique 2. Le fluide caloporteur a donc traversé l'élément magnétocalorique 3 dudit module thermique 2 de la chambre froide 5 vers la chambre chaude 4, tandis que l'arrangement magnétique 7 était disposé de manière à soumettre ledit élément magnétocalorique 3 à un champ magnétique, ce qui a induit un échauffement dudit élément magnétocalorique 3. Lors du passage du fluide caloporteur à travers l'élément magnétocalorique 3, un échange thermique a eu lieu entre ces derniers et le fluide s'est échauffé avant d'atteindre la chambre chaude 4 correspondante.

Dans le cycle suivant, après rotation de l'arrangement magnétique 7 et des platines de commutation 121 et 122, l'élément magnétocalorique 3 du module thermique 2 situé dans la partie supérieure de la figure 2 ne sera plus soumis à un champ magnétique et le fluide sera déplacé de la gauche vers la droite. Pour ce faire, les platines de commutation 121 et 122 vont tourner de telle sorte qu'un passage traversant 18 de la platine de commutation 122 relié au circuit d'aspiration 141 du flasque de distribution 17 correspondant sera positionné face à la chambre froide 5 tandis qu'un passage traversant 19 de la platine de commutation 121 relié au circuit de refoulement 151 du flasque de distribution 16 correspondant sera positionné face à la chambre chaude 4 du même module thermique 2. Le fluide caloporteur traversera l'élément magnétocalorique 3 dudit module thermique 2 de la chambre chaude 4 vers la chambre froide 5, tandis que l'élément magnétocalorique 3 se refroidira. Le passage du fluide caloporteur à travers l'élément magnétocalorique 3 permettra de réaliser un échange thermique entre ces derniers entraînant un refroidissement du fluide caloporteur se dirigeant vers la chambre froide 5.

Le fond des chambres chaude 4 et froide 5 est de préférence ouvert et les platines de commutation 121 et 122 assurent l'étanchéité de ces dernières. A cet effet, un carter 23 peut contenir les chambres chaudes 4 et un carter 24 peut contenir les chambres froides 5, et ces carters 23 et 24 peuvent être munis chacun d'un rebord circulaire 13 destiné à coopérer avec le flanc de la platine de commutation 121 ou 122 correspondante en vue de réaliser une étanchéité entre ladite platine de commutation 121 ou 122 et les chambres chaudes 4 ou froides 5 correspondantes. Un moyen d'étanchéité tel qu'un joint peut également être disposé entre ces éléments. Toute autre forme d'assemblage et de moyens d'étanchéité peut être prévue.

Ces carters 23 et 24 sont en contact avec les chambres chaudes 4 et froides 5 et peuvent donc être utilisés en tant qu'échangeurs thermiques.

Dans une variante non représentée, un seul carter peut contenir l'ensemble des chambres chaudes 4 et froides 5 ainsi que l'ensemble des éléments magnétocaloriques 3 et comporter, au niveau de chacune de ses extrémités, ledit rebord circulaire 13. Un tel carter pourrait, en outre, être constitué par deux demi-coquilles assemblées selon un plan longitudinal dudit générateur thermique 1.

En outre, les éléments magnétocaloriques 3 peuvent également être intégrés dans un carter 22, comme cela est représenté dans les figures annexées.

Dans l'exemple de réalisation représenté, les platines de commutation 121 et 122 sont identiques. Elles sont sous la forme d'un disque plein comportant des paires de passages traversants 18 destinés à être reliés au circuit d'aspiration 141, réalisés à la hauteur ou en regard de ce dernier en position de montage du générateur thermique 1, et disposés en alternance avec des paires de passages traversants 19 destinés à être reliés au circuit de refoulement 151 et réalisés à la hauteur ou en regard de ce dernier en position de montage dudit générateur thermique 1. Lesdites platines de commutation 121, 122 sont montées dans le générateur thermique 1 de manière à être décalées angulairement de 45°, cet angle correspondant à celui séparant deux zones aimantées consécutives de l'arrangement magnétique 7. Un tel agencement permet de changer le sens de déplacement des pistons 6 et donc du fluide caloporteur au niveau de l'élément magnétocalorique 3 de chaque module thermique 2 de manière synchronisée avec la variation d'un champ magnétique sollicitant ledit élément magnétocalorique 3.

En d'autres termes, lorsque l'élément magnétocalorique 3 d'un module thermique 2 est soumis à un champ magnétique et s'échauffe, les platines de commutation 121 et 122 sont disposées de manière à entraîner les pistons 6 pour réaliser un déplacement du fluide caloporteur de la chambre froide 5 vers la chambre chaude 4 dans ce module thermique 2. Inversement, lorsque ce même élément magnétocalorique 3 n'est plus soumis au champ magnétique et qu'il se refroidit, les platines de commutation 121 et 122 sont disposées de manière à entraîner les pistons 6 pour réaliser un déplacement du fluide caloporteur de la chambre chaude 4 vers la chambre froide 5 dans ce module thermique 2.

Les passages traversants 18 et 19 sont constamment en relation fluidique avec les circuits d'aspiration 141 et de refoulement 151. Ainsi, lorsqu'un passage traversant 18 ou 19 se trouve en regard d'une chambre chaude 4 ou froide 5, il permet, par aspiration ou refoulement du fluide, le déplacement du piston 6 disposé dans cette chambre.

Bien que l'ensemble des dessins annexés illustrent un générateur thermique 1 comportant une seule unité constituée par un assemblage de modules thermiques 2 disposés en cercle autour de l'axe central A, l'invention prévoit également la réalisation d'un générateur thermique présentant une structure étagée avec plusieurs unités. Une telle configuration permet d'augmenter le rendement du générateur thermique selon l'invention.

### Possibilités d'application industrielle :

Il ressort clairement de cette description que l'invention permet d'atteindre les buts fixés, à savoir proposer un générateur thermique 1 de construction simple et peu encombrante limitant le nombre d'organes de manoeuvre pour la circulation du fluide caloporteur dans les modules thermiques 2 et résolvant les problèmes d'étanchéité dus à la manoeuvre des moyens de déplacement du fluide caloporteur.

Un tel générateur thermique 1 peut trouver une application aussi bien industrielle que domestique dans le domaine du chauffage, de la climatisation, du tempérage, refroidissement ou autres, ce, à des coûts compétitifs et dans un faible encombrement.

En outre, toutes les pièces composant ce générateur thermique 1 peuvent être réalisées selon des processus industriels reproductibles.

La présente invention n'est pas limitée à l'exemple de réalisation décrit mais s'étend à toute modification et variante évidentes pour un homme du métier tout en restant dans l'étendue de la protection définie dans les revendications annexées.

## Revendications

1. Générateur thermique (1) comprenant au moins un module thermique (2) essentiellement constitué par un élément magnétocalorique (3) agencé pour être traversé par un fluide caloporteur et deux chambres chaude (4) et froide (5) disposées de part et d'autre de l'élément magnétocalorique (3) et renfermant chacune un moyen (6) de déplacement dudit fluide caloporteur à travers ledit élément magnétocalorique (3), un arrangement magnétique (7) agencé pour créer une variation de champ magnétique dans ledit élément magnétocalorique (3) de manière à créer alternativement dans ledit élément magnétocalorique (3) un cycle d'échauffement et un cycle de refroidissement, et un dispositif d'entraînement (8) desdits moyens de déplacement (6) selon un mouvement de va-et-vient dans la chambre (4 ou 5) concernée pour imprimer un déplacement au fluide caloporteur de part et d'autre dudit élément magnétocalorique (3) et de manière synchronisée avec la variation de champ magnétique afin de générer la création puis le maintien d'un gradient de température entre les deux extrémités opposées (9 et 10) dudit élément magnétocalorique (3), générateur **caractérisé en ce que** le dispositif d'entraînement (8) comporte un circuit fermé de fluide reliant fluidiquement lesdites chambres chaude (4) et froide (5) dans lequel un fluide de manoeuvre est entraîné par un dispositif d'aspiration et de refoulement (11), et au moins une interface de commutation (12) synchronisée avec ledit arrangement magnétique (7) pour relier alternativement chaque chambre chaude (4) et froide (5) aux côtés aspiration (14) et refoulement (15) dudit dispositif (11) d'aspiration et de refoulement et inversement.

2. Générateur thermique selon la revendication 1, **caractérisé en ce que** le fluide de manoeuvre et le fluide caloporteur sont les mêmes.

3. Générateur thermique selon l'une quelconque des revendications 1 et 2, **caractérisé en ce que** ladite interface de commutation (12) comporte au moins une platine de commutation (121, 122) montée dans ledit générateur thermique (1) et intercalée entre une des chambres chaude (4) ou froide (5) dudit module thermique (2) et un flasque de distribution (16, 17) muni d'un circuit d'aspiration (141) et d'un circuit de refoulement (151) reliés respectivement aux côtés aspiration (14) et refoulement (15) du dispositif (11) d'aspiration et de refoulement.

4. Générateur thermique selon la revendication 3, **caractérisé en ce que** ladite platine de commutation (121, 122) comporte des passages traversants (18 et 19) assurant une communication fluidique entre lesdites chambres chaude (4) et froide (5) et les circuits d'aspiration (141) et de refoulement (151) dudit flasque de distribution (16, 17).

5. Générateur thermique, selon l'une quelconque des revendications précédentes, présentant une structure circulaire comportant une pluralité de modules thermiques (2) disposés en cercle autour d'un axe central (A), **caractérisé en ce qu'**il comprend deux interfaces de commutation (12) comportant chacune une platine de commutation (121, 122), **en ce que** lesdites platines de commutation (121 et 122) et les flasques de distribution (16, 17) correspondants sont également circulaires et **en ce que** les circuits d'aspiration (141) et de refoulement (151) desdits flasques de distribution (16, 17) sont sous la forme de deux rainures concentriques réalisées sur leur face située en regard desdites platines de commutation (121, 122).

6. Générateur thermique, selon la revendication 5, dans lequel l'arrangement magnétique (7) est concentrique à l'axe central (A) et entraîné en rotation autour dudit axe (A), **caractérisé en ce que** les platines de commutation (121, 122) et l'arrangement magnétique (7) sont entraînés en rotation autour dudit axe central (A) par le même actionneur.

7. Générateur thermique, selon la revendication 5, **caractérisé en ce que** l'arrangement magnétique est fixe et constitué par des électroaimants reliés à une source d'énergie électrique et **en ce que** les platines de commutation (121, 122) sont entraînées en rotation autour dudit axe central (A) par un actionneur spécifique.

8. Générateur thermique, selon l'une quelconque des revendications 5 à 7, **caractérisé en ce que** les platines de commutation (121, 122) sont identiques et sont montées décalées angulairement l'une par rapport à l'autre de telle sorte que chaque module thermique (2) est relié, d'une part, au niveau de sa chambre chaude (4) ou froide (5), à un passage traversant (18) d'une platine de commutation (121 ou 122) relié au circuit d'aspiration (141) d'un flasque de distribution (16 ou 17) et, d'autre part, au niveau de sa chambre froide (5) ou chaude (4), à un passage traversant (19) de l'autre platine de commutation (122 ou 121) relié au circuit de refoulement (151) de l'autre flasque de distribution (17 ou 16).

9. Générateur thermique, selon la revendication 8, **caractérisé en ce que** l'arrangement magnétique (7) comporte une alternance de zones aimantées et de zones non aimantées et **en ce que** les passages traversants (18, 19) des platines de commutation (121, 122) sont disposées en fonction de ladite alternance, pour réaliser un déplacement du fluide caloporteur dans chaque module thermique (2) de la chambre chaude (4) vers la chambre froide (5) lorsque l'élément magnétocalorique (3) n'est pas soumis à un champ magnétique et de la chambre froide (5) vers la chambre chaude (4) lorsque l'élément magnétocalorique (3) est soumis à un champ magnétique.

10. Générateur thermique, selon l'une quelconque des revendications 5 à 9, **caractérisé en ce que** l'ensemble des chambres chaudes (4) et l'ensemble des chambres froides (5) sont contenus dans un carter (23, 24) constituant un échangeur thermique.

## Claims

1. Heat generator (1) comprising at least one thermal module (2) composed essentially of a magnetocaloric element (3) arranged for being crossed by a heat transfer fluid and two hot (4) and cold (5) chambers arranged on each side of the magnetocaloric element (3) and each containing a means (6) for displacing said heat transfer fluid through said magnetocaloric element (3), a magnetic arrangement (7) arranged for creating a magnetic field variation in said magnetocaloric element (3) so as to create alternately in said magnetocaloric element (3) a heating cycle and a cooling cycle, and a device (8) for driving said displacement means (6) according to a reciprocating movement in the concerned chamber (4 or 5) for communicating a displacement to the heat transfer fluid on either end of said magnetocaloric element (3) in synchronization with the magnetic field variation in order to create and then maintain a temperature gradient between the two opposite ends (9 and 10) of said magnetocaloric element (3), generator **characterized in that** the drive device (8) comprises a closed fluid circuit connecting fluidically said hot (4) and cold (5) chambers in which a manoeuvring fluid is driven by a suction and discharge device (11), and at least one switching interface (12) synchronised with said magnetic arrangement (7) for alternately connecting each hot (4) and cold (5) chamber to the suction (14) and discharge (15) sides of said suction and discharge device (11) and inversely.

2. Heat generator according to claim 1, **characterized in that** the manoeuvring fluid and the heat transfer fluid are the same.

3. Heat generator according to any one of claims 1 and 2, **characterized in that** said switching interface (12) includes at least one switching plate (121, 122) mounted in said heat generator (1) and inserted between one of the hot (4) or cold (5) chambers of said thermal module (2) and a distribution flange (16, 17) provided with a suction circuit (141) and a discharge circuit (151) connected respectively to the suction (14) and discharge (15) sides of the suction and discharge device (11).

4. Heat generator according to claim 3, **characterized in that** said switching plate (121, 122) includes run-through passages (18 and 19) providing a fluidic communication between said hot (4) and cold (5) chambers and the suction (141) and discharge (151) circuits of said distribution flange (16, 17).

5. Heat generator according to any of the previous claims, presenting a circular structure comprising a plurality of thermal modules (2) arranged in a circle around a central axis (A), **characterized in that** it includes two switching interfaces (12), each comprising a switching plate (121, 122), **in that** said switching plates (121 and 122) and the corresponding distribution flanges (16, 17) are also circular and **in that** the suction (141) and discharge (151) circuits of said distribution flanges (16, 17) are in the form of two concentric grooves made on their face located in front of said switching plates (121, 122).

6. Heat generator according to claim 5, in which the magnetic arrangement (7) is concentric to the central axis (A) and driven in rotation around said axis (A), **characterized in that** the switching plates (121, 122) and the magnetic arrangement (7) are driven in rotation around said central axis (A) by the same actuator.

7. Heat generator according to claim 5, **characterized in that** the magnetic arrangement is fixed and is made up of electromagnets connected to an electrical power source and **in that** the switching plates (121, 122) are driven in rotation around said central axis (A) by a specific actuator.

8. Heat generator according to any of claims 5 to 7, **characterized in that** the switching plates (121, 122) are identical and are mounted in an angular offset with respect to each other so that each thermal module (2) is connected, on the one side, at the level of its hot (4) or cold (5) chamber, to a run-through passage (18) of a switching plate (121 or 122) connected to the suction circuit (141) of a distribution flange (16 or 17) and, on the other side, at the level of its cold (5) or hot (4) chamber, to a run-through passage (19) of the other switching plate (122 or 121) connected to the discharge circuit (151) of the other distribution flange (17 or 16).

9. Heat generator according to claim 8, **characterized in that** the magnetic arrangement (7) comprises an alternation of magnetized zones and non-magnetized zones and **in that** the run-through passages (18, 19) of the switching plates (121, 122) are arranged according to said alternation, for displacing the heat transfer fluid in each thermal module (2) from the hot chamber (4) to the cold chamber (5) when the magnetocaloric element (3) is not subjected to a magnetic field and from the cold chamber (5) to the hot chamber (4) when the magnetocaloric element (3) is subjected to a magnetic field.

10. Heat generator according to any of claims 5 to 9, **characterized in that** all the hot chambers (4) and all the cold chambers (5) are contained in a housing (23, 24) forming a heat exchanger.

## Patentansprüche

1. Thermischer Generator (1) mit mindestens einem Wärme-Modul (2), welches im Wesentlichen aus einem magnetokalorischen Element (3) besteht, das ausgelegt ist, um von einem Wärmeübertragungsfluid durchströmt zu werden, und aus einer warmen (4) und einer kalten (5) Kammer, die beidseitig des magnetokalorischen Elements (3) angeordnet sind und jeweils ein Mittel (6) zur Zirkulation des besagten Wärmeübertragungsfluids durch das besagte magnetokalorische Element (3) enthalten, eine magnetische Anordnung (7), die ausgelegt ist, um eine Magnetfeld-Variation in dem besagten magnetokalorischen Element (3) zu erzeugen, um abwechselnd in dem besagten magnetokalorischen Element (3) einen Heiz-Zyklus und einen Kühl-Zyklus zu erzeugen, und eine Antriebs-Vorrichtung (8) um die besagten Zirkulations-Mittel (6) in der betroffenen Kammer (4 oder 5) in einer Hin-und-Her-Bewegung anzutreiben, um das Wärmeübertragungsfluid in beide Richtungen und mit der Magnetfeld-Variation synchronisiert durch das besagte magnetokalorische Element (3) zu fördern, um einen Temperaturgradienten zwischen den beiden entgegen gesetzten Enden (9 und 10) des besagten magnetokalorischen Elements (3) zu erzeugen und aufrecht zu halten, **dadurch gekennzeichnete**r Generator, dass die Antriebs-Vorrichtung (8) einen geschlossenen Kreislauf aufweist, der eine Fluidverbindung zwischen der besagten warmen (4) und kalten (5) Kammer herstellt, in dem ein Betätigungsfluid durch eine Ansaug- und Fördervorrichtung (11) in Bewegung versetzt wird, und zumindest eine mit der besagten magnetischen Anordnung (7) synchronisierte Umschalt-Schnittstelle (12), um abwechselnd jede warme (4) und kalte (5) Kammer mit der Ansaug-Seite (14) und mit der Förder-Seite (15) der besagten Ansaug- und Fördervorrichtung (11) und umgekehrt zu verbinden.

2. Thermischer Generator nach Anspruch 1, **dadurch gekennzeichnet, dass** das Betätigungsfluid und das Wärmeübertragungsfluid dieselben sind.

3. Thermischer Generator nach einem beliebigen der Ansprüche 1 und 2, **dadurch gekennzeichnet, dass** die besagte Umschalt-Schnittstelle (12) zumindest eine Umschalt-Platte (121, 122) beträgt, die in dem besagten thermischen Generator (1) eingebaut ist und zwischen einer der warmen (4) oder kalten (5) Kammern des besagten Wärme-Moduls (2) und einem Verteilungsflansch (16, 17) angeordnet ist, wobei letzterer mit einem Ansaug-Kreislauf (141) und einem Förder-Kreislauf (151) versehen ist, die mit der Ansaug-Seite (14) bzw. mit der Förder-Seite (15) der Ansaug- und Fördervorrichtung (11) verbunden sind.

4. Thermischer Generator nach Anspruch 3, **dadurch gekennzeichnet, dass** die besagte Umschalt-Platte (121, 122) durchgehende Öffnungen (18 und 19) beträgt, die eine Fluidverbindung zwischen den besagten warmen (4) und kalten (5) Kammern und dem Ansaug-Kreislauf (141) und dem Förder-Kreislauf (151) des besagten Verteilungsflanschs (16, 17) herstellen.

5. Thermischer Generator nach einem beliebigen der vorhergehenden Ansprüche, der eine kreisförmige Struktur aufweist mit einer auf einem Kreis um eine Mittelachse (A) angeordneten Vielzahl von Wärme-Modulen (2), **dadurch gekennzeichnet, dass** er zwei Umschalt-Schnittstellen (12) umfasst, die jeweils eine Umschalt-Platte (121, 122) betragen, dadurch, dass die besagten Umschalt-Platten (121 und 122) und die entsprechenden Verteilungsflansche (16, 17) ebenfalls kreisförmig sind, und dadurch, dass der Ansaug-Kreislauf (141) und der Förder-Kreislauf (151) der besagten Verteilungsflansche (16, 17) die Form von zwei konzentrischen Nuten annehmen, die auf der gegenüber der besagten Umschalt-Platten (121, 122) liegenden Seite ausgeführt sind.

6. Thermischer Generator nach Anspruch 5, in dem die magnetische Anordnung (7) zur Mittelachse (A) konzentrisch ist und um die besagte Achse (A) in Drehung angetrieben wird, **dadurch gekennzeichnet, dass** die Umschalt-Platten (121, 122) und die magnetische Anordnung (7) durch den selben Antrieb um die besagte Mittelachse (A) in Drehung angetrieben werden.

7. Thermischer Generator nach Anspruch 5, **dadurch gekennzeichnet, dass** die magnetische Anordnung fest steht und aus mit einer elektrischen Energiequelle verbundene Elektromagneten besteht und dadurch, dass die Umschalt-Platten (121, 122) durch einen spezifischen Antrieb um die besagte Mittelachse (A) in Drehung angetrieben werden.

8. Thermischer Generator nach einem beliebigen der Ansprüche 5 bis 7, **dadurch gekennzeichnet, dass** die Umschalt-Platten (121, 122) identisch und zueinander winkelversetzt angeordnet sind, so dass jedes Wärme-Modul (2) einerseits durch seine warme (4) oder kalte (5) Kammer mit einer mit dem Ansaug-Kreislauf (141) eines Verteilungsflanschs (16 oder 17) verbundenen durchgehenden Öffnung (18) einer Umschalt-Platte (121 oder 122) verbunden ist und, andererseits, durch seine kalte (5) oder warme (4) Kammer mit einer mit dem Förder-Kreislauf (151) des anderen Verteilungsflanschs (17 oder 16) verbundenen durchgehenden Öffnung (19) der anderen Umschalt-Platte (122 oder 121) verbunden ist.

9. Thermischer Generator nach Anspruch 8, **dadurch gekennzeichnet, dass** die magnetische Anordnung (7) eine Abwechslung von magnetisierten und nicht magnetisierten Bereichen beträgt und dadurch, dass die durchgehenden Öffnungen (18, 19) der Umschalt-Platten (121, 122) entsprechend der besagten Abwechslung angeordnet sind, um das Wärmeübertragungsfluid in jedem Wärme-Modul (2) von der warmen Kammer (4) in die kalte Kammer (5) zu fördern wenn das magnetokalorische Element (3) keinem Magnetfeld ausgesetzt ist und von der kalten Kammer (5) in die warme Kammer (4) zu fördern wenn das magnetokalorische Element (3) einem Magnetfeld ausgesetzt ist.

10. Thermischer Generator nach einem beliebigen der Ansprüche 5 bis 9, **dadurch gekennzeichnet, dass** alle warmen Kammern (4) und alle kalten Kammern (5) jeweils in einem einen Wärmetauscher bildenden Gehäuse (23, 24) untergebracht sind.
